# EUROPEAN PATENT APPLICATION

(11) **EP 2 151 863 A1**
(43) Date of publication of application: **10.02.2010**
(21) Application number: 08161526.2
(22) Date of filing: 31.07.2008
(51) Int. Cl.: H01L 23/473

(54) **A jet impingement cooling system**

(71) Applicant: LUCENT TECHNOLOGIES INC., Murray Hill NJ 07974-0636 (US)
(72) Inventor: Salamon, Todd Richard, Chatham, NJ 07928 (US); Lyons, Alan Michael, New Providence, NJ 07974 (US)
(74) Representative: Fitchett, Stuart Paul

(57) **Abstract**

A jet impingement cooling system (1) for an electronic device (3) comprises: a housing (4); a substrate to be cooled (5) located in the housing which substrate is arranged to be in thermal contact with the device to be cooled and which has a surface pattern (14) thereon; a fluid inlet (8) to the housing; at least one fluid outlet (9) from the housing; and at least one nozzle (17) in fluid connection with the fluid inlet for directing a jet (12) of fluid at a portion of the substrate, wherein that the surface pattern (14) defines at least one channel (19) and the jet is aligned with the pattern (14) such that at least a portion of the jet is incident on at least a portion of the channel (19) such that the flow of the fluid from the jet is subsequently confined by the channel (19). The arrangement assists in maximizing the cooling effect of the fluid on a given area of substrate.

## Description

### Field of the Invention

The present invention relates to jet impingement cooling of an electronic device.

### Background of the Invention

The continued increase in device densities in electronics equipment results in significant challenges in developing efficient, reliable and low-cost cooling technologies capable of dissipating the ever-increasing heat loads associated with these devices. Examples of such electronics equipment range from computer chips to the circuit packs that are present in the racks of communication equipment in the central offices of telecommunications providers. Increasing heat dissipation requirements can affect device design, for example, with some chips now having to use multi-core processors, as the heat removal requirements of a single core processor with similar functionality would not be met by existing cooling technologies.

The heat dissipation requirements for communications equipment are the most stringent of all electronics equipment, with racks of communications equipment typically requiring three to four times more heat dissipation per unit footprint than, for example, a farm of computer servers.

Many technologies for cooling electronics equipment with high heat dissipation rates rely on convective cooling, where heat is transferred to a working fluid such as air or water. This reliance on convection is because the high heat dissipation rates of these devices can no longer be effectively handled by conductive cooling alone. Convection enhances heat transfer in two ways. First, it can increase the local heat transfer coefficient, i.e. the efficiency of heat transfer, at the device surface through efficiently bringing cool working fluid into contact with the hot surface. A laminar jet impinging directly upon a heated substrate is one such example. Boiling and turbulent flow are two additional examples that also utilize convective flow to enhance heat transfer. Second, by increasing the rate of convection, e.g. the mass flow rate of the fluid, one can effectively increase the magnitude of the heat sink to which the device can dissipate energy. Increasing the rate of convection also often results in an increase in the efficiency of heat transfer, often characterized via a heat transfer coefficient h, defined at the boundary between the hot surface and the cooling fluid. For example, the transition from laminar to turbulent flow results in a substantial increase in the heat transfer efficiency, i.e. heat transfer coefficient h.

The working fluid may be used in an open- or closed-loop configuration, can be driven by either forced or natural convection, and can operate in single or two-phase modes. In single-phase heat transfer the cooling arises from the working fluid absorbing heat from the device and increasing in temperature. In two-phase heat transfer the working fluid also undergoes a phase change, typically from a liquid to a gas, with the latent heat associated with the change of phase providing additional cooling capacity.

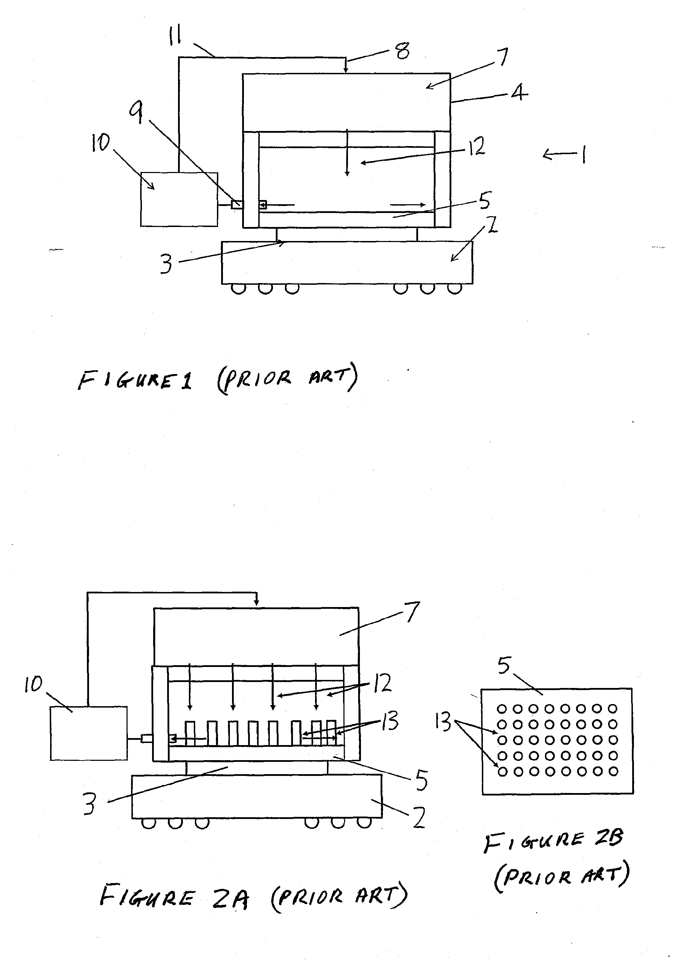

In the open-loop configuration heat is transferred from the device (heat source) to a continuous supply of working fluid (heat sink), where, once the requisite amount of heat has been transferred to the working fluid, the fluid leaves the device. The open-loop configuration thus relies on a continuous supply of working fluid acting as the heat sink. In the closed-loop configuration (see Figure 1), a fixed amount of working fluid is continuously recirculated within the cooling device, with the working fluid absorbing heat from the electronic component and then dissipating this heat to an external heat sink such as, for example, an air-cooled heat exchanger.

In both the closed and open-loop configurations it is particularly challenging to efficiently take advantage of the heat carrying capacity, or sensible heat, of the working fluid because of the high local heat dissipation rates associated with a typical high-performance electronic device, i.e. it is difficult to design a device that is able to transfer the high heat fluxes occurring at the device surface to the working fluid. Technologies that address efficient heat transfer for high surface heat fluxes include microchannel cooling, heat pipes, jet impingement cooling and synthetic jets. Each of these technologies is described in detail below.

### Microchannel cooling

Microchannel cooling utilizes narrow (< 1 mm) channels to efficiently transfer heat to a working fluid flowing in a channel, where the channel wall is in good thermal contact with the heated device. In laminar, single-phase channel flow the fluid flow is primarily parallel to the channel walls, so that there is essentially no convective mixing to enhance heat transfer. This results in the presence of a thermal boundary layer that develops adjacent to the channel wall. Narrow channels are required to reduce the conductive resistance to the bulk of the fluid that is associated with this thermal boundary layer. The efficiency of heat transfer can be shown to be inversely proportional to the channel height. Configurations using simultaneous evaporation/boiling and microchannel flow enhance heat transfer by taking advantage of the additional cooling associated with the liquid-gas phase change, enhanced surface convection/mixing due to boiling, and reduced pressure drops due to the presence of a low-viscosity gas phase.

A significant disadvantage of microchannel cooling is that there is a substantial pressure drop across the channel due to the small channel size. This is because the pressure drop for laminar flow between two infinite, parallel plates scales inversely with the cube of the channel height, e.g. DP ∼ 1/H^3, where DP is the pressure drop across the channel and H is the channel height. This puts stringent cost, efficiency (with respect to energy usage), long-term reliability and size requirements on pumps for driving fluid flow through microchannels.

### Heat pipes

Heat pipes transfer heat by boiling/evaporating a liquid from a porous liquid-saturated wick that is in good thermal contact with the heated portion of the device and then transporting the vapor to a heat sink away from the device where the vapor is recondensed. The recondensed liquid is then transported back to the heated portion of the device, thereby forming an evaporative cooling loop. The vapour and liquid flows are typically driven by the capillary pressure generated in the liquid-saturated wick.

One drawback to heat pipes is that, if they rely on gravity to feed the condensed fluid back to the heated portion of the heat pipe, the operation of the heat pipe can be configuration dependent. A second drawback is that, due to challenges in fabricating porous wick structures that simultaneously have high effective thermal conductivity, generate large capillary pressures and are highly porous, heat pipes can only accommodate a limited amount of heat transfer through them before they fail due to boiling or dry out. Thus for devices with high heat fluxes heat pipes may not be a viable cooling technology.

### Jet impingement cooling

Jet impingement cooling directs a stream of fluid (liquid or gas) onto a solid substrate (see Figure 1). The impinging jet can operate in submerged or non-submerged modes. In the submerged mode the impinging fluid is identical to the surrounding fluid, e.g. a water jet in a water environment. In the non-submerged mode the impinging fluid is different from the surrounding fluid, e.g. a water jet in an air environment. Jet impingement cooling achieves very efficient heat transfer rates for several reasons. First, since the jet is typically oriented normal to the heated surface the jet is extremely efficient at bringing cool fluid to the heated surface. This is in contrast to microchannel cooling where the flow is essentially parallel to the substrate. Second, the jet impingement induces secondary flows that result in efficient mixing of heated fluid near the hot surface with cool fluid away from the hot surface. Third, turbulent jets enhance heat transfer because of the enhanced local mixing that occurs on the varying length scales associated with the turbulence. Last, combining boiling with jet impingement results in enhanced heat transfer due to the phase change and enhanced convection associated with boiling.

It has been shown that pinned fin heat sinks, where cylindrical posts protrude vertically away from the flat surface of a heat sink (see Figure 2), are able to enhance heat transfer to impinging jets. The diameter of the cylindrical pinned fin is typically of the order of the jet diameter, and the jet is often aligned directly with the center of the top surface of the pinned fin for maximum heat transfer. This particular geometry is relatively easy to manufacture using extrusion processes.

Jet impingement cooling has a similar drawback to microchannel cooling in that the large pressure drop associated with creation of a suitable jet puts stringent cost, efficiency (with respect to energy usage), long-term reliability and size requirements on pumps for jet creation. This is particularly true for the case of turbulent jets, where the additional pumping capacity required for a turbulent flow is substantial relative to that of a laminar jet, i.e. the slope of the pressure drop versus flow rate for a jet in the turbulent regime is much larger than the corresponding jet in the laminar regime. A hierarchical, tree-like double-branching manifold has attempted to address the issue of large pressure drops, although the use of silicon processing technology for creating such a device adds significant manufacturing costs, (T Brunschwiler, H Rothuizen, M Fabbri, U Kloter, B Michel, R J Bezama and G Natarajan, "Direct Liquid Jet-Impringement Cooling with Micron-Sized Nozzle Array and Distributed Return Architecture", The Tenth Intersociety Conference on Thermal and Thermomechanical Phenomena in Electronics Systems, 2006. ITHERM '06, pp 196-203, May 30 - June 2, 2006). Other drawbacks with jet impingement cooling using arrays of jets are that: i) fluid flow from adjacent jets can interact with one another; and ii) placement of exit manifold(s) in a multiple jet array system can have profound implications on the overall heat transfer characteristics of the system.

Many experimental and theoretical studies have examined the heat transfer effects of applying controlled roughness to the surface that the jet impinges. These studies have concluded that roughness elements can enhance heat transfer by: i) disrupting thermal boundary layers that develop along the surface; ii) if the roughness features are of sufficient size relative to the scale of the jet impingement flow they can create secondary flows that result in enhanced mixing; and iii) increasing the surface area of the substrate, thereby increasing the area available for heat transfer to the fluid.

### Synthetic jets

A synthetic jet consists of a cavity with an actuator, typically a diaphragm or membrane that can oscillate in a controlled, periodic fashion, at one end and an orifice at the other end. Oscillation of the actuator results in the formation of a jet in the surrounding fluid. This device results in a jet with no net mass flux from the synthetic jet into the surrounding flow - the jet formation occurs entirely from the surrounding fluid. The synthetic jet can increase heat transfer rates, for example, in channel flow by: i) impinging fluid normal to a heated surface; ii) disrupting thermal boundary layers that may develop along a channel wall; and iii) inducing long-range mixing due to the presence of secondary flows associated with the jet.

Synthetic jets have the disadvantage of issues related to the potential long-term reliability of the moving parts that make up the actuator portion of the device. Synthetic jets also typically require some MEMS fabrication ability, which can add substantially to the cost of the cooling assembly.

### Summary of The Invention

According to the present invention there is provided a jet impingement cooling system for an electronic device, the system comprising: a housing; a substrate to be cooled located in the housing which substrates is arranged to be in thermal contact with the device to be cooled and which has a surface pattern thereon; a fluid inlet to the housing; at least one fluid outlet from the housing; and at least one nozzle in fluid connection with the fluid inlet for directing a jet of fluid at a portion of the substrate, characterized in that the surface pattern defines at least one channel and the jet is aligned with the pattern such that at least a portion of the jet is incident on at least a portion of the channel and wherein the flow of the fluid from the jet is subsequently confined by the channel.

The present invention improves heat transfer associated with the primary impinging jet flow by modification of the surface directly underneath the impinging jet. Additionally, the channels conveying the fluid away from the primary flow create secondary flows that transfer additional heat from the substrate. In addition, by receiving the jet of cooling fluid into the channels, the channels can be arranged to control interaction between adjacent jets in a system having multiple jets within the housing.

In one embodiment, the pattern comprises a plurality of walls upstanding from the surface of the substrate, the walls intersecting at and extending radially from a point aligned with the centre of the jet to define a plurality of wedge shaped sections, each section defining a channel. With this arrangement, the walls increase the surface area in contact with the jet and additionally confine the jet and control the subsequent flow of the fluid.

Alternatively, the pattern may comprise a three dimensional lattice structure, wherein the jet is aligned with an upper surface of the lattice such that the fluid of the jet is received into the lattice, the lattice defining a plurality of channels conveying liquid from the jet to peripheral walls of the lattice structure. The lattice structure greatly increases the surface area with which the jet comes into contact and again subsequently controls the flow of fluid away from the jet. The density of the lattice structure may vary from the upper surface to a bottom surface of the lattice. This enables the tailoring of thermal conductivity and resistance to fluid flow of the three dimensional lattice structure.

In a further alternative embodiment of the present invention, the pattern may comprise a plurality of upstanding planar fins. These again increase the surface area with which the impinging jet comes into contact with. The fins are preferably arranged to form a plurality of circular walls having different diameters, the circular walls being arranged concentrically with their centres aligned with the centre of the jet, each wall having a plurality of apertures therein defined by the spacing between adjacent fins, the apertures of each wall being positionally staggered relative to the apertures of an adjacent wall, and the spacing between adjacent walls and between adjacent fins defining a plurality of channels.

The above arrangement results in the liquid being directed radially away from the jet. However, as each successive wall intersects the flow emanating from the apertures in the previous wall, the fluid is successively directed on to the fins of each successive wall. This arrangement also prevents interaction between jets in a multi-jet arrangement.

In a further alternative embodiment, the pattern may define a plurality of grooves extending radially, the grooves intersecting at a recess in the substrate aligned with the jet. Here the channels act to increase the surface area with which the fluid comes into contact and to control the flow of fluid away from the jet.

Where the channels are in the form of grooves, defined by upstanding fins or by upstanding walls, at least a portion of at least one channel may be covered to form at least one closed duct. This maximises the surface area in contact with the fluid flowing in the channel, with the exit flow being forced through the channel resulting in control of the exit flow of fluid away from the jet. Preferably, the pattern defines a plurality of ducts extending radially from an open and central portion aligned with the jet. It may also be preferable that the pattern additionally defines a lattice structure formed in the substrate in the open and central portion into which the nozzle may extend.

Preferably, at least a portion of one wall of the duct is corrugated in a direction transverse to the direction of fluid flow through the duct. This has the advantage of inducing recirculatory flows away from the impingement jet and enhances local mixing and heat transfer.

The system may comprise a plurality of nozzles and a plurality of raised portions formed on the substrate, each aligned with a respective nozzle. The regions surrounding the raised portions then form an outflow path in fluid connection with at least one said fluid outlet. Each raised portion has a substantially identical pattern formed thereon, with the channels of each pattern extending to the outflow path or paths. This arrangement permits very efficient heat transfer immediately below the jet where it impinges on the patterned substrate where the secondary flow of fluid away from the jet flow is controlled by confinement within the channels of the pattern. The channels convey the fluid to the outflow paths and thus prevent interaction between adjacent jets which may otherwise reduce the cooling efficiency of the jets.

Geometrical shapes may be formed in the channels to disrupt flow within the channels, thus preventing one-dimensional or parallel surface flow which can reduce heat transfer to the fluid because of the formation of boundary layers.

The jets may be pulsed or the nozzles apertures varied at a variable frequency to further enhance cooling by causing further disturbance of the fluid flow across the surface of the substrate.

According to a further aspect of the present invention, there is provided a method of manufacturing a pattern of the above described system, the method comprising the steps of using an ink jet printing to create the pattern surface as a plastic part and then using an investment casting process to create a corresponding metal pattern. This provides a process for reproducibly, reliably and economically manufacturing structures with precisely controlled geometry.

The above described embodiments can provide improved cooling of a substrate in a single or multiple jet impingement system without the requirement to increase flow rate. This can be important for the substrate surface of existing designs may be modified without the need to modify the housing, or to increase fluid flow by using a larger pump, which may mean that the overall size of the system is increased.

### Brief Description of the Drawings

Several embodiments of the present invention will now be described, by way of example only, with reference to the accompanying drawings, in which like numerals are used to indicate like parts and of which:
Figures 1 and 2 are examples of known jet impingement cooling systems;
Figures 3a to Figure 16 illustrate specific examples of surface pattern which can be applied to the system illustrated in Figure 2A to provide a system in accordance with the present invention.

### Detailed Description of the Drawings

Referring to Figure 1, a closed loop jet impingement cooling system, illustrated generally as 1, comprises a ball grid array 2 on which an integrated circuit 3 is mounted. A housing 4 is mounted to the integrated circuit by means of substrate 5, which is a good thermal conductor such as a metal. The housing further comprises a coolant reservoir 7 and a fluid inlet 8 and a fluid outlet 9.

The fluid outlet 9 is connected to a heat exchanger 10 which in turn returns fluid via line 11 to the reservoir 7. The system may additionally comprise a pump (not shown) for circulating the fluid around the system. Fluid, which may be a liquid, from the reservoir is forced through a nozzle to form a jet 12 which impinges on the substrate 5 to be cooled. Heat created by the electronic device 3 is transferred via the substrate 5 to the fluid of the jet, where it is subsequently transferred to the heat exchanger 10, which may be an air cooled. This is a closed loop system, where the fluid is recirculated, but alternatively an open looped configuration could be used, requiring a continuous supply of a working fluid from an external source.

Referring to Figure 2, there is illustrated a modification of the system of Figure 1. In the Figure 2 arrangement, the substrate 5 has a plurality of pins 13 formed thereon which are of the same conductive material as the main body of the substrate 5. The pins are typically produced by a extrusion technique. The system comprises a plurality of jets 12 aligned with at least some of the pins 13 and having a diameter of the same order as the pins. A planar view of the pin configuration is provided in Figure 2b.

A system illustrated in Figures 2a and 2b works in the same manner as described above with reference to Figure 1. However the effective surface area of the substrate 5 is increased by having the plurality of pins 13 mounted thereon.

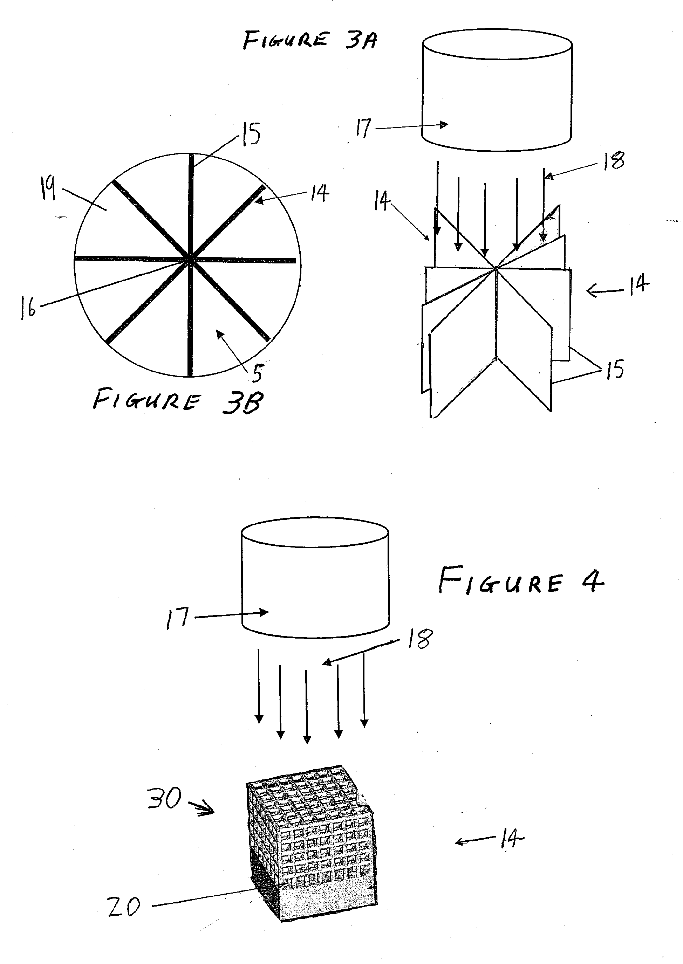

Referring to Figures 3a and 3b, there is illustrated a first example of surface pattern 14 which, in accordance with the present invention, can be produced on a surface of the planar substrate 5 of Figure 1 or on the surface of one or more of the pins 13 of Figures 2a and 2b. It is in any case preferable that the pattern is placed on a raised portion of a substrate, such that outflow paths are defined between adjacent patterns 14. The pattern 14 of Figures 3a and 3b is formed by an extrusion technique and comprises four equally spaced, radially extending walls 15, intersecting at a common central point 16. The surface pattern 14 is aligned with a nozzle 17 from which a jet 18 of cooling fluid impinges on the pattern 14. The walls 15 provide an increased surface area for the fluid to come into contact with, increasing the heat transferred from the substrate 5.

Adjacent walls 15 define wedge shaped shaped channels 19, which channels 19 confine the flow of fluid, forcing it to pass over the surface of the substrate 5 in a radial manner. Thus, the flow from the jet is controlled and, in a multi-jet arrangement, can be arranged to reduce any interference resulting from the flow paths of fluid from adjacent jets interacting in a manner which can reduce the cooling effect experienced by the substrate 5.

Referring now to Figure 4, there is illustrated a perspective view of an alternative embodiment where the surface pattern 14 is in the form of a lattice structure with very fine scale geometric features. This has properties similar to that of a porous media and can be formed by an ink jet printing method and subsequent investment casting techniques. The jet 18 from nozzle 17 impinges upon the surface pattern and passes into the structure, wherein channels 20 confine the flow of the fluid such that it exits the sidewalls of lattice structure in a controlled manner. The lattice structure is preferably raised above the level of the substrate 15 because, where multiple lattice structures and corresponding jets are employed, the region between the lattice structure form an outlet flow path to the outlet 9 of the system minimizing any interaction of fluid flows from adjacent jets.

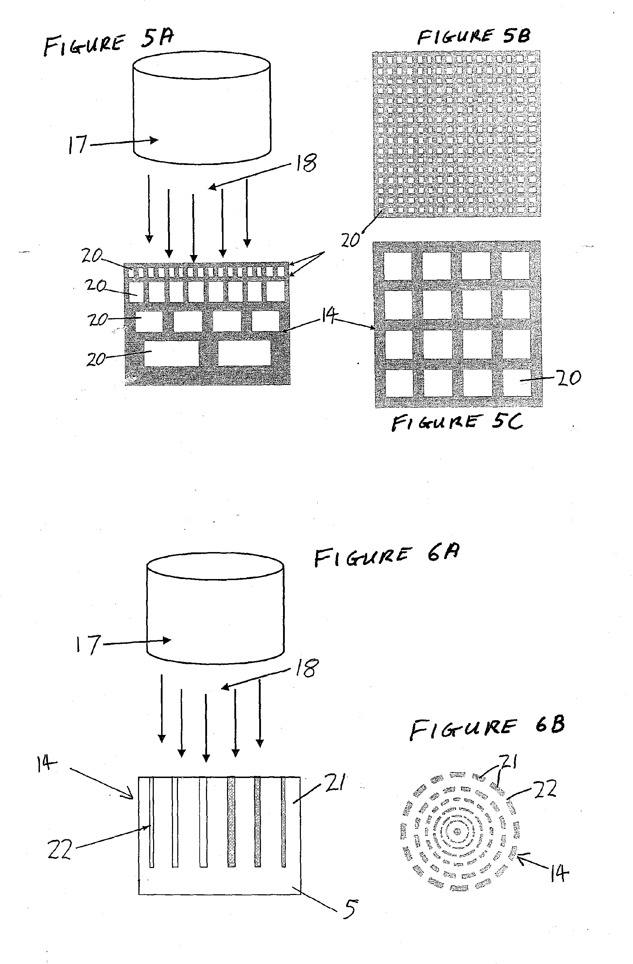

A modification to the lattice structure of figure 4 is shown in Figures 5a, 5b and 5c, where Figure 5a is a partial perspective view and partial side elevation; Figure 5b is a top view; and Figure 5c is a bottom view. In this modification the dimensions of the channels increase from the upper surface to the lower surface. This permits the thermal conductivity of the structure and permeability (resistance to fluid flow) of the structure to be varied with vertical position.

A further alternative embodiment is illustrated in Figures 6a and 6b, where the pattern comprises a plurality of fins 21 upstanding from the surface of the substrate 5. The fins are planer and arranged in concentric circles centred on a point coincident with the centre of the jet 18. The fins define concentric walls having apertures 22 therein, which apertures are staggered relative to the apertures in adjacent walls, so that the flow of fluid from the centre is itself forced to take a staggered flow path when exiting from the pattern structure. The fins 21 increase the cooling surface area and control the subsequent secondary flow, ensuring reimpingement turbulent flow occurs across substantially the whole of the raised area on which the fins are formed.

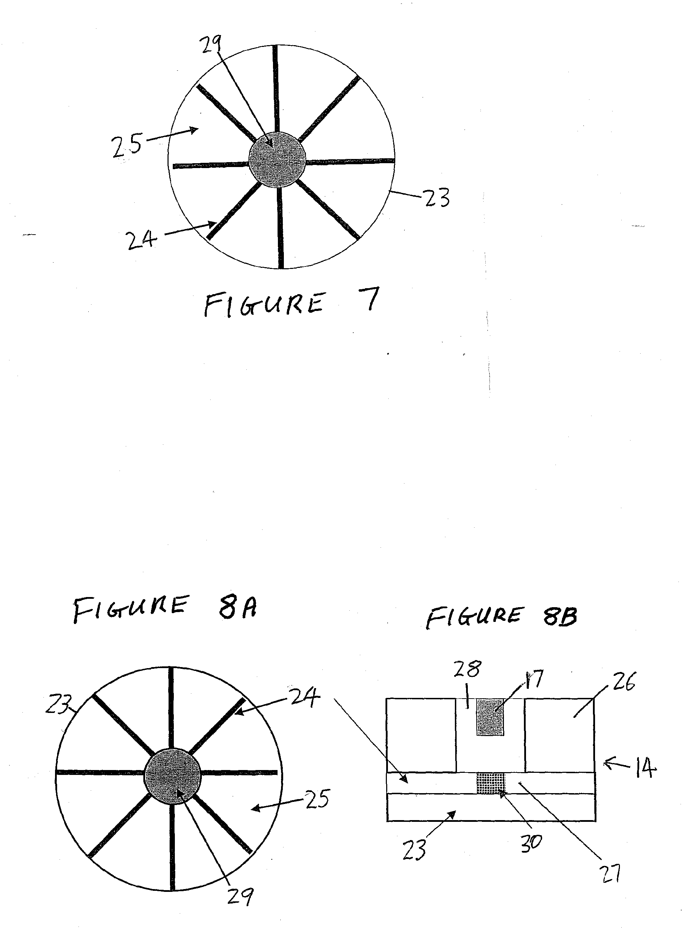

In yet a further alternative embodiment, illustrated in Figure 7, the substrate preferably again comprises a raised portion 23 into which are machined a plurality of radially extending grooves 24, defining a plurality of lands 25 with channels therebetween. In this case, the area of the impinging jet, represented by shaded area 29 is less than the area raised portion 23 and the dimensions of the channels 24 are of a sufficient width and depth so that radial flow through the channels is preferred to flow over the substrate surface.

In Figures 8a and 8b, a modification of the arrangement of figure 7 is illustrated, where the channels 24 are enclosed by a further structure 26 of the pattern, which structure encloses the channels so that they form ducts extending from a central region 27 to the periphery of the raised portion 23. In the centre of the pattern, an aperture 28 is formed into which nozzle 17 protrudes. Thus fluid from the nozzle 17 is forced to flow through the channels 24. The surface pattern may additionally comprise a lattice structure 30 of the type illustrated in Figures 4 or 5.

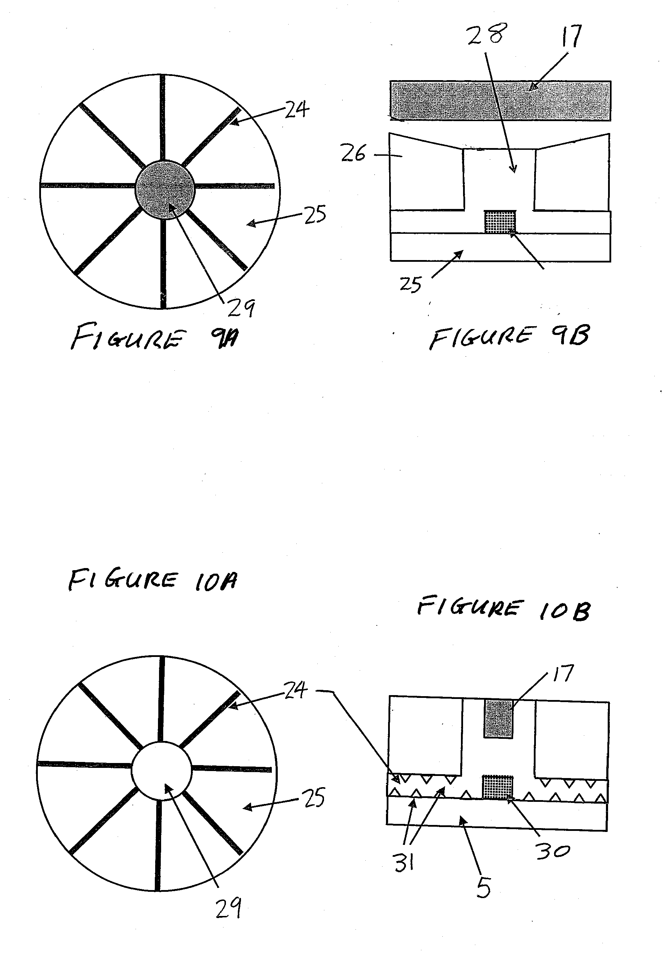

In a slight modification to the embodiment depicted in Figures 8a and 8b, the area of the nozzle 17 is greater than the aperture 28 and the upper surface of the structure 26 has a tapered chamfer to direct the flow towards the aperture 28, as shown in Figures 9a and 9b.

Figures 10a and 10b illustrate an embodiment similar to that of Figures 8a and 8b, but wherein the output channel 24 additionally comprises corrugations 31 on its upper and lower surfaces to induce recirculatory flows and enhance local mixing and heat transfer.

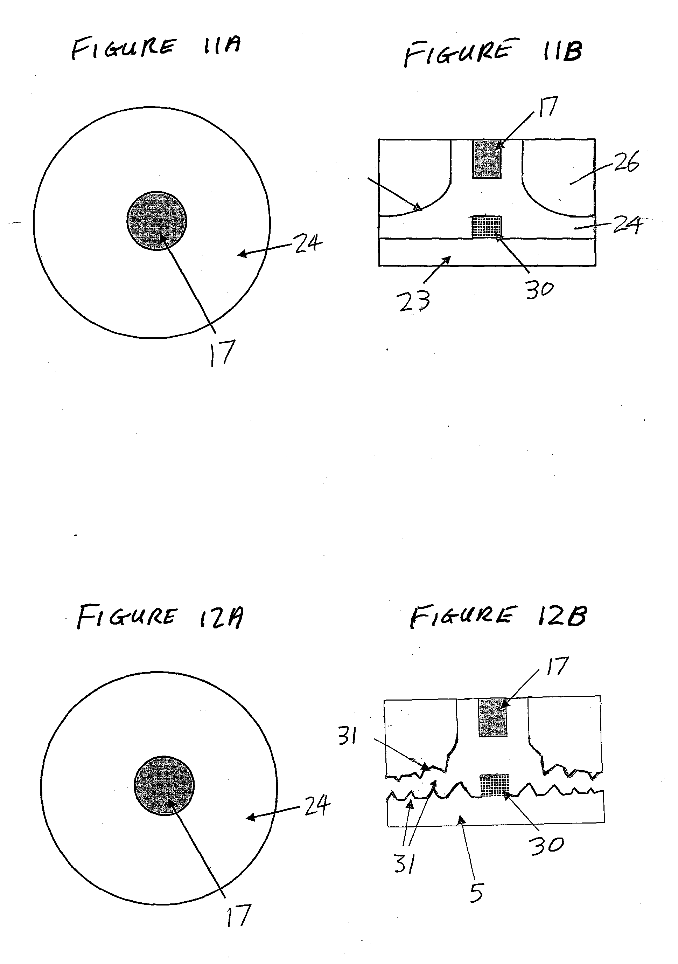

In the embodiment illustrated in Figures 11a and 11b, the spacing between the substrate 5 and an enclosing structure 26, formed as part of the patterned surface, defines a channel 24 wherein the vertical spacing is inversely proportional to the distance from the centre of the nozzle 17, such that the circumferential area of the cross section of the channel is constant as the width of the channel increases away from the centre. Thus the velocity at any point within the channel 24 is constant. Again, the channel may have radially spaced corrugations as shown in the similar embodiment illustrated in Figures 12a and 12b.

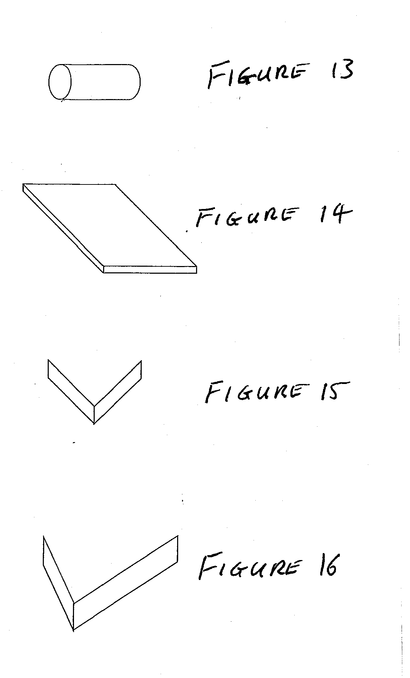

The corrugations described above can be replaced with any of the number of variety of local roughness features that are capable of inducing mixing and enhancing heat transfer. These local roughness features are small enough so as not to have a qualitative effect on the macroscopic flow field, i.e. primary, secondary or exit flow in which they are placed. Such local features may be in the form of geometric shapes as illustrated in any one of Figures 13 to 16. Local geometric features can enhance mixing by mechanisms including disrupting thermal boundary lines, tripping the flow to become turbulent and generating flow fields more amenable to mixing and heat transfer. Also, synthetic jets can be placed along the substrate surface to further induce local mixing and heat transfer.

In any of the above embodiments, the impinging jets may be pulsed utilising different frequencies to induce secondary flows. A flow associated with the time dependent flow field will generate additional mixing and thereby enhanced heat transfer. In addition, or alternatively thereto, the shape of the nozzle or orifice can be modified, possibly in conjunction with the pattern surface, so as to maximise heat transfer, such modifications might change the nozzle from circular to square or triangular or similar arrangements. Also the various pattern structures have been described with reference to use with a single phase, non-submerged jet, but it will be appreciated that many of the structures can equally be used in submerged configurations and can use two phase cooling.

The above embodiments have been described by way of example only and many alternative embodiments and modifications will be apparent to the skilled person, which alternatives and modifications are within the scope of the appended claims.

## Claims

1. A jet impingement cooling system (1) for an electronic device (3) comprises: a housing (4); a substrate to be cooled (5) located in the housing which substrate is arranged to be in thermal contact with the device (3) to be cooled and which substrate has a surface pattern (14) thereon; a fluid inlet (8) to the housing; at least one fluid outlet (9) from the housing; and at least one nozzle (17) in fluid connection with the fluid inlet for directing a jet (12) of fluid at a portion of the substrate, **characterized in that:** the surface pattern (14) defines at least one channel (19); the jet (12) is aligned with the pattern such that at least a portion of the jet is incident on at least a portion of the at least one channel; and the at least one channel (19) confines at least a portion of the subsequent fluid flow from the jet.

2. A system as claimed in Claim 1, wherein the pattern (14) comprises a plurality of walls (15) upstanding from the surface of the substrate, the walls intersecting at and extending radially from a point (16) aligned with the centre of the jet (12) to define a plurality of wedge shaped sections each section defining a channel (19).

3. A system as claimed in Claim 1, wherein the pattern (14) comprises a three dimensional lattice structure (30) and the jet (12) is aligned with an upper surface of the lattice structure such that it is received into the lattice, the lattice defines a plurality of channels (20) conveying liquid from the jet to peripheral walls of the lattice structure.

4. A system as claimed in Claim 3, wherein the vertical density of the lattice structure varies from an upper surface to a lower surface of the lattice structure (30).

5. A system as claimed in Claim 1, wherein the pattern (14) comprises a plurality of upstanding planer fins (21).

6. A system as claimed in Claim 5, wherein the fins (21) are arranged to form a plurality of circular walls having different diameters, the circular walls being arranged concentrically with their centres aligned with the centre of the jet (18), each wall having a plurality of apertures (22) therein defined by the spacing between adjacent fins (21), the apertures of each wall being positionally staggered relative to the apertures (22) of an adjacent wall, the spacing between adjacent walls and between adjacent fins (21) defining a plurality of channels (19).

7. A system as claimed in Claim 1, wherein the pattern (14) defines a recess aligned with the jet and a plurality of grooves (24) extending radially from the recess defining a plurality of channels.

8. A system as claimed in Claim 1, 2 or 7, wherein at least a portion of at least one channel (24) is covered to form at least one closed duct.

9. A system as claimed in Claim 8, wherein the at least one closed duct has a first end for receiving fluid from the jet (18) and a second end from which the fluid is discharged; the width of the duct progressively increases from said first end to said second end; the depth of the duct progressively decreasing from said first end to the second end; and the circumferential cross-sectional area of the duct is constant along the length of the duct.

10. A system as claimed in Claim 8 or 9, wherein the pattern (14) defines a plurality of ducts extending radially from an open central portion (28) aligned with the jet.

11. A system as claimed in Claim 10, wherein the pattern (14) additionally defines a lattice structure (30) formed on the substrate in the open central portion.

12. A system as claimed in Claim 10 or 11, wherein the nozzle (17) extends into the open portion (28).

13. A system as claimed in any one of Claim 8 to 12, wherein at least a portion of one inner wall of the duct is corrugated in a direction transverse to the direction of fluid flow through the duct.

14. A system as claimed in any preceding claim, comprising a plurality of nozzles (17) and having a plurality of raised portions (25) formed on the substrate each aligned with a respective nozzle, the regions surrounding the raised portions forming an outflow path in fluid contact with the at least one fluid outlet (9), each raised position having a substantially identical pattern (14) formed thereon with the channels of each pattern extend to the outflow paths.

15. A system as claimed in any preceding claim, wherein the pattern (14) further defines geometrical shapes in said channels (19) arranged to disrupt flow within the channels.

16. A system as claimed in any preceding claim, wherein the jets (12) are pulsed.

17. A system as claimed in any preceding claim, wherein the shape of the nozzles (17) is changed.

18. A method of manufacturing a pattern of a system as claimed in any preceding claim, comprising the steps of using ink jet printing to create the patterned surface as a plastic part and using an investment casting process to create a corresponding metal pattern.
